# EUROPEAN PATENT SPECIFICATION

(11) **EP 0 742 443 B1**
(45) Date of publication and mention of the grant of the patent: **30.01.2002**
(21) Application number: 96302810.5
(22) Date of filing: 22.04.1996
(51) Int. Cl.: G01R 21/133, G01R 21/00, G01R 11/24, G01D 4/00

(54) **Improvements in or relating to electricity meters**
Verbesserter Elektrizitätszähler
Amélioration de compteurs électriques

(30) Priority: 06.05.1995 GB 9509303
(43) Date of publication of application: 13.11.1996
(73) Proprietor: SIEMENS METERING LIMITED, Oldham, Lancashire OL9 7JS (GB)
(72) Inventor: Graham, Ian, Ramsbottom, Bury, Lancashire BL0 9YD (GB); Green, Jonathan Peter, Todmorden, Lancashire OL14 6LW (GB); Cowburn, John William, Darwen, Lancashire BB3 2LG (GB)
(74) Representative: Allen, Derek

(56) References cited:
- EP-A- 0 163 440
- EP-A- 0 598 521
- GB-A- 2 280 290
- US-A- 5 173 657

## Description

This invention relates to modulised utility meters, and more especially it relates to modulised electricity meters.

Such meters are the subject of GB-A-2 295 681, GB-A-2 295 682, GB-A-2 295 683, GB-A-2 300 722, GB-A-2 300 719, GB-A-2 300 724 and GB-A-2 300 721 (corresponding to our co-pending patent application numbers 9424461.3, 9501771.1, 9501772.9, 9509282.1, 9509279.7, 9509304.3 and 9509281.3 respectively), to which attention is hereby directed.

Modulised electricity meters comprise a basic meter module with which 'add-on' modules can be operatively associated to extend functionality and for example, a basic credit meter module may be converted to a pre-payment module by the operative addition of an 'add-on' module arranged to receive pre-payment tokens or the like.

The 'add-on' module may actually be fitted to the basic meter module or it may be positioned remote from it (i.e. in a convenient position to receive tokens or smart cards).

Modulised electricity meters have the advantage that basic parts required for metering can be included in the basic meter module, the 'add-on' module being arrange to include those parts necessary for the additional functions required, e.g. a pre-payment function or a radio tele-meter function.

One problem with modulised meters is that they tend to be more vulnerable to fraudulent attempts to obtain supplies of the utility concerned without appropriate payment. For example, it might be possible with modulised meters for a fraudster to obtain (perhaps by theft) an 'add-on' module containing 'credits' for supply of the utility, which 'add-on' module can be fitted to a basic meter module so that the 'credits' can be used.

GB-A-2 280 290 discloses a commodity metering apparatus for combatting fraud when supplying electricity to a consumer. The commodity metering apparatus comprises a fraud unit connected to a consumer unit, the fraud unit meters the supplied energy which is then measured by the consumer unit. The fraud unit is located remote from the consumer unit. The value of electricity consumed which is stored on the fraud unit is compared with that stored on the consumer unit, the consumer unit requesting the fraud unit to transmit its value as encrypted data and once decrypted, a comparison is made. If there is a discrepancy between the value stored on the fraud unit and that stored on the consumer unit, the consumer unit registers a fraud attempt. The fraud and consumer units each contain an ID code and a key which is used to confirm that data relating to the consumption of electricity is genuine, that is, obtained from a particular fraud and consumer unit combination.

EP-A-0 598 521 discloses a modular commodity consumption meter comprising a basic module and at least one 'add-on' module for providing an ancillary function to the metering of the commodity. The basic module meters the commodity and supplies signals to the 'add-on' module indicative of the rate of consumption of the commodity and whether the passage of the commodity is to or away from the consumer. The modules, when assembled together, have the appearance of a single unitary module.

It is an important object of the present invention to provide a modulised utility meter which is resistant to this kind of fraud.

According to the present invention, a modulised utility meter is provided for measuring the consumption of a utility, the modulised utility meter is comprising:- a basic meter module which is adapted for fixture in the premises of a consumer, the basic meter module including a central processor unit for controlling operation thereof and for providing a first storage register for the quantity of the utility consumed and a second storage register for identification data appertaining thereto; an 'add-on' meter module which is provided to extend the functionality of the basic meter module, the 'add-on' meter module including a central processor unit for controlling operation thereof and for providing a first storage register for the quantity of the utility consumed and a second storage register for identification data appertaining thereto; and comparator means provided in at least one meter module for comparing the data stored in the storage registers of the modules and for providing at least one output signal in the absence of predetermined correspondence therebetween; characterised in that the comparator means comprises first and second comparators for comparing the data stored in the first storage registers and the second storage register respectively, and threshold means for applying a threshold to the output signal from the first comparator to provide an output signal when that threshold is exceeded; and in that the threshold means comprises a threshold filter unit and a filter setting unit, the threshold filter being determined by the setting of the filter setting unit to account for predetermined allowable differences between the data in the first storage registers and to allow the output signal to be adjustable.

The comparator means may be part of the central processor unit in the 'add-on' meter module. Alternatively, the comparator means may be part of the basic meter module.

The identification data may be arranged to correspond to a serial number or to some other identification number unique to the modulised utility meter, whereby the same data is normally stored in the central processor unit of both the 'add-on' meter module and the basic meter module, the signal being provided if the data stored in each module is not substantially identical.

Preferably, the basic meter module and the 'add-on' meter module each comprises meter means for the utility supplied, the first storage register in each meter module being arranged to store data corresponding to the quantity of the utility as measured by the meter means.

The modulised meter may be a modulised electricity meter and the 'add-on' meter module may be a pre-payment module adapted to receive tokens or the like in pre-payment for the electricity to be supplied.

The 'add-on' meter module may be adapted to be contiguously received by the basic meter module.

Advantageously, each meter module is provided with an optical communication port which is operable under control of the central processor unit in the meter module in which it is positioned, the optical communication ports being positioned and arranged so that communication therebetween is facilitated when the meter modules are mutually contiguously and operatively associated so as to facilitate communication between the meter modules of the modulised meter.

One embodiment of the invention will now be described by way of example only, with reference to the accompanying drawings, in which,

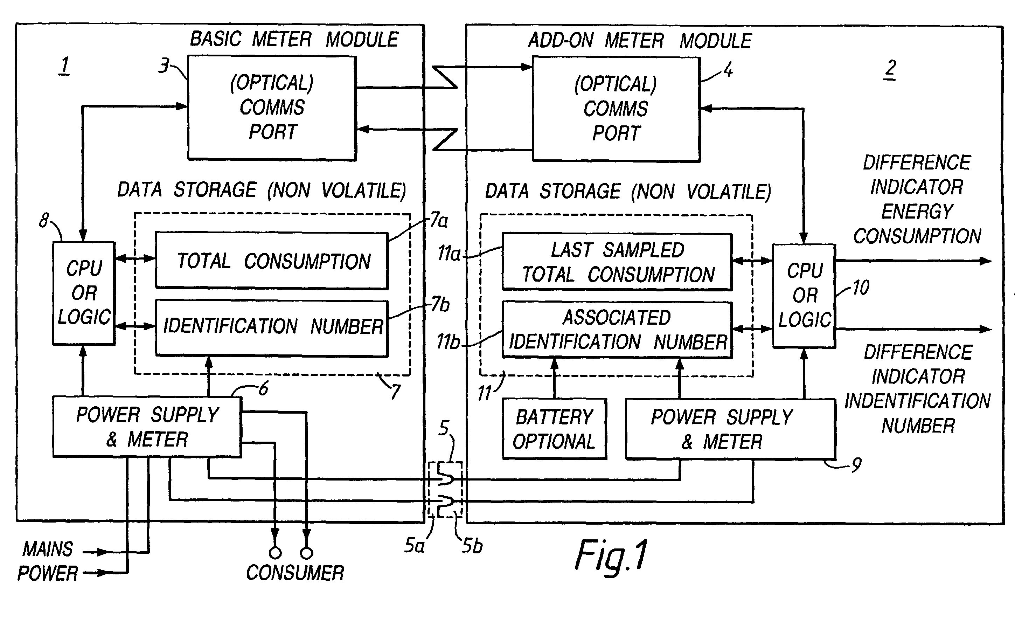

FIGURE 1 is a somewhat schematic circuit block diagram of a modulised electricity meter, comprising a basic meter module, operatively associated with an 'add-on' meter module, and,
FIGURE 2 is a block circuit diagram showing in greater detail a part of the circuit block diagram shown in Figure 1.

Referring now to the drawings, wherein corresponding parts of the two Figures bear, as appropriate, the same numerical designations, a modulised electricity meter comprises a basic meter module 1, adapted contiguously to receive an 'add-on' module 2. The basic meter module 1 is provided with a housing (not shown) which is arranged to facilitate fitment of the module 1 in the premises of a consumer. The 'add-on' module 2, which is provided to extend the functionality of the basic meter module 1, is provided with a housing (not shown) which enables it to be fitted to, and to be arranged to be received in interlocking engagement by the basic meter module 1, so that it is mechanically supported by the basic meter module 1 and suitably coupled to the basic meter module 1, optically and electrically to support required functionality. This coupling comprises optical communication ports 3 and 4 in the modules 1 and 2 respectively, and an electrical plug and socket connector 5 having plug/socket parts 5a, 5b. The optical communication ports 3, 4 and the parts 5a and 5b of the plug and socket connector 5 are arranged to be mutually aligned consequent upon fitment of the 'add-on' module 2 to the basic meter module 1, so that optical communication and electrical coupling is provided.

The basic meter module 1 comprises a meter and power supply unit 6, a store 7 and a central processor unit (CPU) 8, which serves to control operation of the meter and the optical communication port 3. The store 7 includes storage registers 7a and 7b for data relating to the quantity of electricity consumed, as measured by the basic meter module 1, and data relating to a unique identification number appertaining to the basic meter module 1, respectively.

Similarly, the 'add-on' meter module 2 includes a power supply and meter unit 9, a CPU 10 and a store 11, which includes storage registers 11a and 11b, for data appertaining to electricity used, as measured by the 'add-on' meter 2 and an identification number associated with the 'add-on' meter module 2, respectively. In the present example, the 'add-on' meter module 2 is a pre-payment module and accordingly means are provided (not shown) for registering pre-payment credits in accordance with the provision of tokens or the like. Thus, the register 11a would normally be provided with a digital display for the quantity of electricity which for the time being is available for use.

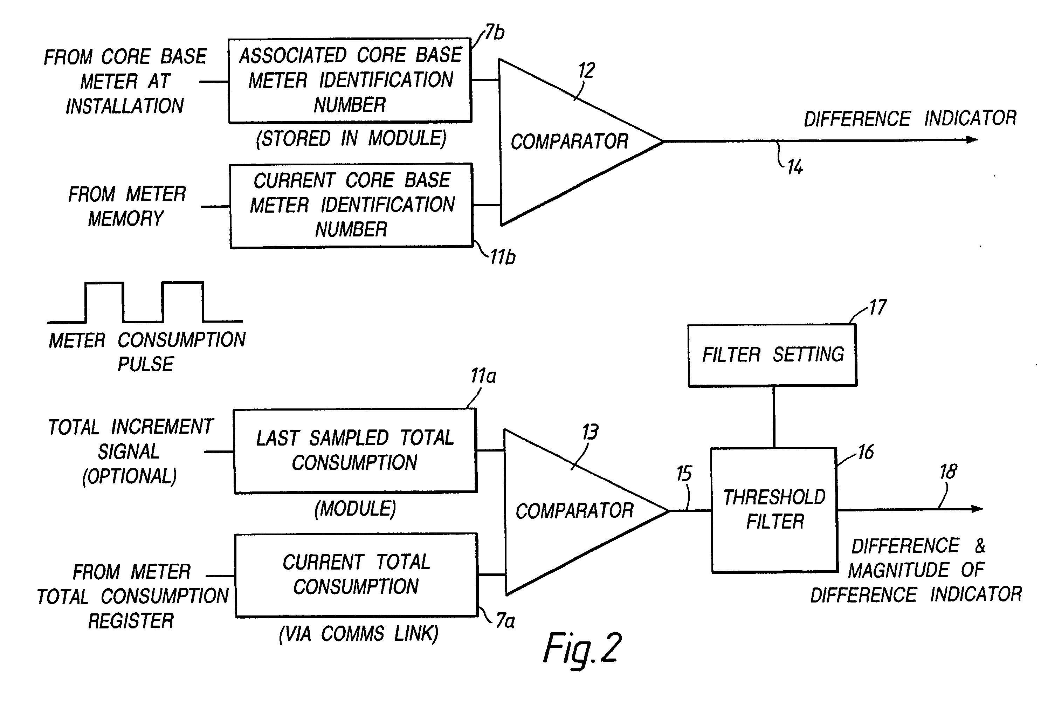

In this embodiment of the invention, two comparators 12 and 13 are included in the CPU 10 of the 'add-on' meter 2 as shown in Figure 2, although in an alternative embodiment they may be included in the CPU 8 of the basic meter module 1. The comparator 12 serves to compare data in the registers 7b and 11b respectively, which relates to the identification numbers of the respective modules 1 and 2, and provides an output signal on a line 14 if an expected relationship between this data does not obtain. For example, the basic meter module 1 and the 'add-on' meter module 2, may have the same identification number which corresponds to the modulised meter assembly of which they both form a part, and if precise correspondence does not obtain between the data as compared by the comparator 12, a predetermined output signal will be provided on the line 14.

The comparator 13 on the other hand, receives data from the registers 11 a and 7a, appertaining to the electricity consumption as registered in the 'add-on' module 2 and the basic meter module 1, respectively. If an expected relationship does not obtain between these registers as determined by the comparator 13, an output signal is provided on a line 15.

In order to account for predetermined allowable differences between data in the registers 11a and 7a, a threshold filter 16 is provided, the threshold of which is settable by a filter setting unit 17. In the present example, the threshold filter may simply comprise a threshold level gate, which provides an output signal on a line 18 if a predetermined threshold is exceeded as determined by the setting of the filter setting unit 17 which controls the threshold level.

Thus, it will be appreciated that if the 'add-on' meter module 2 is removed, perhaps by a fraudster, and another 'add-on' meter module is substituted, which may perhaps be stolen, an output signal will be provided on the line 14, since the serial number of the new 'add-on' meter module will not correspond with the expected serial number, and additionally an output signal will be provided on the line 18, since the setting of the register 11a in the substituted 'add-on' module 2 will not correspond with the expected setting.

The signals on the lines 14 and 18 may be used to provide a warning signal, locally or remotely, and additionally the signal on the line 18 may be arranged to reset the register 11a to a true setting as indicated by stored data so that no benefit can be obtained by obtaining a supply without due payment.

Various modifications may be made to the arrangements described without departing from the scope of the invention and for example, the invention may be applied to modulised meters for the supply of other utilities such as gas or water.

## Claims

1. A modulised utility meter for measuring the consumption of a utility, the modulised utility meter comprising:-
a basic meter module (1) which is adapted for fixture in the premises of a consumer, the basic meter module (1) including a central processor unit (8) for controlling operation thereof and including a store for providing a first storage register (7a) for the quantity of the utility consumed and a second storage register (7b) for identification data appertaining thereto;
an 'add-on' meter module (2) which is provided to extend the functionality of the basic meter module (1), the 'add-on' meter module (2) including a central processor unit (10) for controlling operation thereof and including a store for providing a first storage register (11a) for the quantity of the utility consumed and a second storage register (11b) for identification data appertaining thereto; and
comparator means (12, 13, 16, 17) provided in at least one meter module (1, 2) for comparing the data stored in the storage registers (7a, 7b, 11a, 11b) of the modules (1, 2) and for providing at least one output signal (14, 15) in the absence of predetermined correspondence therebetween;
**characterised in that** the comparator means (12, 13, 16, 17) comprises first and second comparators (13,12) for comparing the data stored in the first storage registers (7a, 11a) and the second storage register (7b, 11b) respectively, and threshold means (16, 17) for applying a threshold to the output signal (15) from the first comparator (13) to provide an output signal (18) when that threshold is exceeded;
and **in that** the threshold means (16, 17) comprises a threshold filter unit (16) and a filter setting unit (17), the threshold filter (16) being determined by the setting of the filter setting unit (17) to account for predetermined allowable differences between the data in the first storage registers (7a, 11a) and to allow the output signal (18) from the threshold means (16,17) to be adjustable.

2. A modulised utility meter as claimed in Claim 1, wherein the comparator means (12, 13, 16, 17) is a part of the central processor unit (10) in the 'add-on' meter module (2).

3. A modulised utility meter as claimed in Claim 1, wherein the comparator means (12, 13, 16, 17) is part of the central processor unit (8) in the basic meter module (1).

4. A modulised utility meter as claimed in any one of Claims 1 to 3, wherein the identification data is arranged to correspond to a serial number or to some other identification number unique to the modulised utility meter, the same data being normally stored in the central processor unit (8, 10) of both the 'add-on' meter module (2) and the basic meter module (1), the output signal (14) from the second comparator (12) being provided if the data stored in second storage register (7b, 11b) of each meter module (1, 2) is not substantially identical.

5. A modulised utility meter as claimed in any one of Claims 1 to 4, wherein the basic meter module (1) and the 'add-on' meter module (2) each comprises meter means (6, 9) for the utility supplied, the first storage register (7a, 11a) in each meter module (1, 2) being arranged to store data corresponding to the quantity of the utility as measured by the meter means (6, 9).

6. A modulised utility meter as claimed in any preceding Claim, wherein the modulised utility meter is a modulised electricity meter, and the 'add-on' meter module (2) is a pre-payment module adapted to receive tokens or the like in pre-payment for the electricity to be supplied.

7. A modulised utility meter as claimed in any preceding Claim, wherein the 'add-on' meter module (2) is adapted to be contiguously received by the basic meter module (1).

8. A modulised utility meter as claimed in Claim 7, wherein each meter module (1, 2) is provided with an optical communication port (3, 4) which is operable under control of the central processor unit (8, 10) in the meter module (1, 2) in which it is positioned, the optical communication ports (3, 4) being positioned and arranged so that communication therebetween is facilitated when the meter modules (1, 2) are mutually contiguously and operatively associated so as to facilitate communication between the meter modules (1, 2) of the modulised meter.

## Patentansprüche

1. Modulares Versorgungsmeßgerät zum Messen des Verbrauchs eines Versorgungsmediums, wobei das modulare Versorgungsmeßgerät umfaßt:
ein Basismeßgerät-Modul (1), das so beschaffen ist, daß es am Standort eines Verbrauchers angebracht werden kann, wobei das Basismeßgerät-Modul (1) eine Zentraleinheit (8) umfaßt zum Steuern seines Betriebs, die einen Speicher enthält, der ein erstes Speicherregister (7a) für die Menge des verbrauchten Versorgungsmediums und ein zweites Speicherregister (7b) für zugehörige Identifizierungsdaten bereitstellt;
ein "Erweiterungs"-Meßgerät-Modul (2), das dazu vorgesehen ist, die Funktionalität des Basismeßgerät-Moduls (1) zu erweitern, wobei das "Erweiterungs"-Meßgerät-Modul (2) eine Zentraleinheit (10) umfaßt zum Steuern seines Betriebs, die einen Speicher enthält, der ein erstes Speicherregister (11a) für die Menge des verbrauchten Versorgungsmediums und ein zweites Speicherregister (11b) für zugehörige Identifizierungsdaten bereitstellt; und
ein Vergleichsmittel (12, 13, 16, 17), das in wenigstens einem Meßgerät-Modul (1, 2) vorgesehen ist, um die in den Speicherregistern (7a, 7b, 11a, 11b) der Module (1, 2) gespeicherten Daten zu vergleichen und um bei Fehlen einer vorgegebenen Entsprechung zwischen ihnen wenigstens ein Ausgangssignal (14, 15) zu erzeugen;
**dadurch gekennzeichnet, daß** das Vergleichsmittel (12, 13, 16, 17) erste und zweite Komparatoren zum Vergleichen der in den ersten Speicherregistern (7a, 11a) bzw. in den zweiten Speicherregistern (7b, 11b) gespeicherten Daten sowie ein Schwellenwertmittel (16, 17), das an das Ausgangssignal (15) vom ersten Komparator (13) einen Schwellenwert anlegt, um ein Ausgangssignal (18) zu erzeugen, wenn dieser Schwellenwert überschritten wird, umfaßt;
und daß das Schwellenwertmittel (16, 17) eine Schwellenfiltereinheit (16) und eine Filtersetzeinheit (17) umfaßt, wobei das Schwellenwertfilter (16) durch Setzen mittels der Filtersetzeinheit (17) bestimmt wird, um vorgegebene zulässige Unterschiede zwischen den Daten in den ersten Speicherregistern (7a, 11a) zu berücksichtigen und um zu ermöglichen, daß das Ausgangssignal (18) von dem Schwellenwertmittel (16, 17) einstellbar ist.

2. Modulares Versorgungsmeßgerät nach Anspruch 1, bei dem das Vergleichsmittel (12, 13, 16, 17) ein Teil der Zentraleinheit (10) in dem "Erweiterungs"-Meßgerät-Modul (2) ist.

3. Modulares Versorgungsmeßgerät nach Anspruch 1, bei dem das Vergleichsmittel (12, 13, 16, 17) ein Teil der Zentraleinheit (8) in dem Basismeßgerät-Modul (1) ist.

4. Modulares Versorgungsmeßgerät nach einem der Ansprüche 1 bis 3, bei dem die Identifizierungsdaten so beschaffen sind, daß sie einer Seriennummer oder irgendeiner anderen für das modulare Versorgungsmeßgerät eindeutigen Identifizierungsnummer entsprechen, wobei dieselben Daten normalerweise in der Zentraleinheit (8, 10) sowohl des "Erweiterungs"-Meßgerät-Moduls (2) als auch des Basismeßgerät-Moduls (1) gespeichert sind, wobei das Ausgangssignal (14) vom zweiten Komparator (12) erzeugt wird, falls die im zweiten Speicherregister (7b, 11b) jedes Meßgerät-Moduls (1, 2) gespeicherten Daten nicht im wesentlichen gleich sind.

5. Modulares Versorgungsmeßgerät nach einem der Ansprüche 1 bis 4, bei dem das Basismeßgerät-Modul (1) und das "Erweiterungs"-Meßgerät-Modul (2) jeweils ein Meßmittel (6, 9) für das zugeführte Versorgungsmedium enthalten, wobei das erste Speicherregister (7a, 11a) in jedem Meßgerät-Modul (1, 2) so beschaffen ist, daß es Daten speichert, die der Menge des Versorgungsmediums, die durch die Meßmittel (6, 9) gemessen wird, entsprechen.

6. Modulares Versorgungsmeßgerät nach einem vorhergehenden Anspruch, wobei das modulare Versorgungsmeßgerät ein modularer Elektrizitätsmesser ist und das "Erweiterungs"-Meßgerät-Modul (2) ein Vorauszahlungsmodul ist, das so beschaffen ist, daß es Münzen oder dergleichen als Vorauszahlung für die zu liefernde Elektrizität entgegennimmt.

7. Modulares Versorgungsmeßgerät nach einem vorhergehenden Anspruch, bei dem das "Erweiterungs"-Meßgerät-Modul (2) so beschaffen ist, daß es vom Basismeßgerät-Modul (1) so aufgenommen ist, daß es daran angrenzt.

8. Modulares Versorgungsmeßgerät nach Anspruch 7, bei dem jedes Meßgerät-Modul (1, 2) mit einem optischen Kommunikationsanschluß (3, 4) versehen ist, der unter der Steuerung der Zentraleinheit (8, 10) in dem Meßgerät-Modul (1, 2), in dem es sich befindet, betreibbar ist, wobei die optischen Kommunikationsanschlüsse (3, 4) so angeordnet und beschaffen sind, daß eine Kommunikation zwischen ihnen erleichtert wird, wenn die Meßgerät-Module (1, 2) aneinander angrenzen und funktional einander zugeordnet sind, um die Kommunikation zwischen den Meßgerätmodulen (1, 2) des modularen Meßgeräts zu erleichtern.

## Revendications

1. Dispositif de mesure d'énergie modulaire pour mesurer la consommation d'une énergie, le dispositif de mesure d'énergie modulaire comportant :
un module de mesure basique (1) qui est adapté pour être fixé dans les locaux d'un consommateur, le module de mesure basique (1) comportant une unité de processeur central (8) pour commander son opération et comportant une mémoire pour fournir un premier registre de mémorisation (7a) pour la quantité d'énergie consommée et un second registre de mémorisation (7b) pour des données d'identification concernant celle-ci,
un module de mesure "additionnel" (2) qui est fourni pour étendre la fonctionnalité du module de mesure basique (1), le module de mesure "additionnel" (2) comportant une unité de processeur central (10) pour commander son opération et comportant une mémoire pour fournir un premier registre de mémorisation (11a) pour la quantité d'énergie consommée et un second registre de mémorisation (11b) pour des données d'identification concernant celle-ci, et
des moyens comparateurs (12, 13, 16, 17) agencés dans au moins un module de mesure (1, 2) pour comparer les données mémorisées dans les registres de mémorisation (7a, 7b, 11a, 11b) des modules (1, 2) et pour délivrer au moins un signal de sortie (14, 15) en l'absence d'une correspondance prédéterminée entre celles-ci,
**caractérisé en ce que** les moyens comparateurs (12, 13, 16, 17) comportent des premier et second comparateurs (13, 12) pour comparer les données mémorisées dans les premiers registres de mémorisation (7a, 11a) et les seconds registres de mémorisation (7b, 11b), respectivement, et des moyens de seuil (16, 17) pour appliquer un seuil au signal de sortie (15) provenant du premier comparateur (13) afin de délivrer un signal de sortie (18) lorsque ce seuil est dépassé,
et **en ce que** les moyens de seuil (16, 17) comportent une unité de filtre de seuil (16) et une unité d'ajustement de filtre (17), le filtre de seuil (16) étant déterminé par l'ajustement de l'unité d'ajustement de filtre (17) pour prendre en compte des différence tolérables prédéterminées entre les données dans les premiers registres de mémorisation (7a, 11a) et pour permettre au signal de sortie (18) provenant des moyens de seuil (16, 17) d'être ajustable.

2. Dispositif de mesure d'énergie modulaire selon la revendication 1, dans lequel les moyens comparateurs (12, 13, 16, 17) sont une partie de l'unité de processeur central (10) dans le module de mesure "additionnel" (2).

3. Dispositif de mesure d'énergie modulaire selon la revendication 1, dans lequel les moyens comparateurs (12, 13, 16, 17) sont une partie de l'unité de processeur central (8) dans le module de mesure basique (1).

4. Dispositif de mesure d'énergie modulaire selon l'une quelconque des revendications 1 à 3, dans lequel les données d'identification sont conçues pour correspondre à un numéro de série ou à un certain autre numéro d'identification unique au dispositif de mesure d'énergie modulaire, les mêmes données étant normalement mémorisées dans l'unité de processeur central (8, 10) à la fois du module de mesure "additionnel" (2) et du module de mesure basique (1), le signal de sortie (14) provenant du second comparateur (12) étant délivré si les données mémorisées dans le second registre de mémorisation (7b, 11b) de chaque module de mesure (1, 2) ne sont essentiellement pas identiques.

5. Dispositif de mesure d'énergie modulaire selon l'une quelconque des revendications 1 à 4, dans lequel le module de mesure basique (1) et le module de mesure "additionnel" (2) comportent chacun des moyens de mesure (6, 9) pour l'énergie délivrée, le premier registre de mémorisation (7a, 11a) de chaque module de mesure (1, 2) étant conçu pour mémoriser des données correspondant à la quantité d'énergie telle que mesurée par les moyens de mesure (6, 9).

6. Dispositif de mesure d'énergie modulaire selon l'une quelconque des revendications précédentes, dans lequel le dispositif de mesure d'énergie modulaire est un compteur électrique modulaire, et le module de mesure "additionnel" (2) est un module de pré-paiement adapté pour recevoir des jetons ou analogue pour le pré-paiement de l'électricité à délivrer.

7. Dispositif de mesure d'énergie modulaire selon l'une quelconque des revendications précédentes, dans lequel le module de mesure "additionnel" (2) est adapté pour être reçu de manière contiguë par le module de mesure basique (1).

8. Dispositif de mesure d'énergie modulaire selon la revendication 7, dans lequel chaque module de mesure (1, 2) est muni d'un port de communications optiques (3, 4) qui est opérationnel sous commande de l'unité de processeur central (8, 10) dans le module de mesure (1, 2) dans lequel il est positionné, les ports de communications optiques (3, 4) étant positionnés et conçus de sorte qu'une communication entre ceux-ci est facilitée lorsque les modules de mesure (1, 2) sont mutuellement associés de manière contiguë et opérationnelle de manière à faciliter une communication entre les modules de mesure (1, 2) du dispositif de mesure modulaire.
